Europäisches Patentamt

(19) European Patent Office

Office européen des brevets

(11) Publication number: **0 080 731 B2**

(12) # NEW EUROPEAN PATENT SPECIFICATION

(45) Date of publication of the new patent specification: **21.11.91 Bulletin 91/47**

(51) Int. Cl.⁵: **H01L 29/78, H01L 21/76, H01L 29/08**

(21) Application number: **82111034.3**

(22) Date of filing: **30.11.82**

---

(54) Semiconductor device comprising a buried oxide isolation.

---

(30) Priority: **30.11.81 JP 190641/81**

(43) Date of publication of application:
**08.06.83 Bulletin 83/23**

(45) Publication of the grant of the patent:
**14.09.88 Bulletin 88/37**

(45) Mention of the opposition decision:
**21.11.91 Bulletin 91/47**

(84) Designated Contracting States:
**DE FR GB IT**

(56) References cited:
**EP-A- 0 000 897**
**EP-A- 0 048 175**
**GB-A- 2 036 431**
**US-A- 3 397 448**
**US-A- 3 725 160**
**US-A- 3 986 200**
**US-A- 4 161 039**
**US-A- 4 187 125**

(73) Proprietor: **KABUSHIKI KAISHA TOSHIBA
72, Horikawa-cho Saiwai-ku
Kawasaki-shi Kanagawa-ken 210 (JP)**

(72) Inventor: **Konaka, Masami
1-8, Furuichiba
Saiwai-ku Kawasaki-shi (JP)**
Inventor: **Shibyo, Naoyuki
C-321, Toshiba-Isogo-Dairoku-ryo, 2-8-2
Shiomidai Isogo-ku Yokohama-shi (JP)**
Inventor: **Dang, Ryo
2513-1334, Shiomidai
Isogo-ku Yokohama-shi (JP)**

(74) Representative: **Lehn, Werner, Dipl.-Ing. et al
Hoffmann, Eitle & Partner Patentanwälte
Arabellastrasse 4
W-8000 München 81 (DE)**

EP 0 080 731 B2

## Description

This invention relates to a semiconductor device having an insulating film deposited in substrate recesses surrounding a transistor formation region.

Hitherto, a coplanar process has been employed to isolate semiconductor elements. In this process, however, oxidized regions (called bird's beak) are formed in the lateral direction, resulting in a reduction of the VLSI packing density. That is, the gate oxide film is liable to have a greater thickness than the desired thickness due to the bird's beak. Because of this phenomena, the threshold voltage fluctuations are increased. In an extreme case, the thickness of the gate oxide film becomes substantially equal to the thickness of the field oxide film which results in an open circuit between the source and the drain.

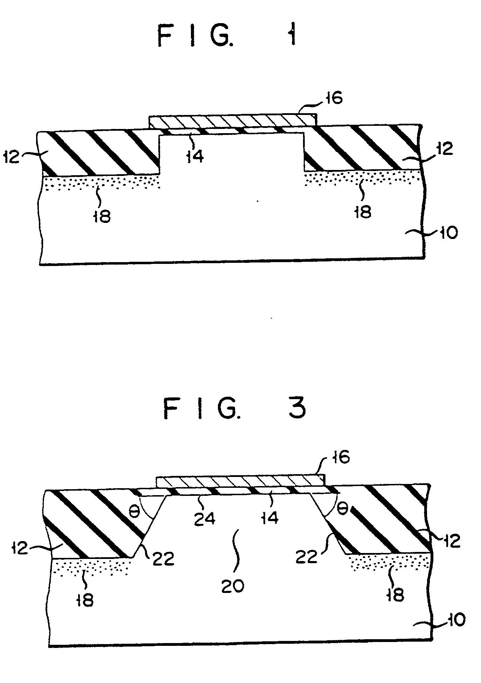

To overcome this drawback, a BOX (buried oxide isolation) process as shown in Fig. 1 has been proposed. This BOX process is disclosed, for instance, in "A New Buried-oxide Field Isolation for VLSI Devices", K. Kurosawa et al. 39-th Annual Device Research Conference, June 22-24, 1981, University of California, Santa Barbara. In this BOX process, a silicon substrate 10 is preliminarily etched to form recesses, and an insulating film 12 is stacked in these recesses. With the deposition of the insulating film 12, the resultant wafer has a flat surface. Over the portion of the substrate 10 surrounded by the insulating film 12, a gate electrode 16 is formed with a gate insulating film 14 interposed therebetween. Usually, an ion implantation layer 18 is formed in a superficial portion of the substrate under the insulating film 12 for preventing an inversion layer from forming. This process does not employ a thermal oxidation step which takes a long time. Thus, the fluctuations of the threshold voltage can be reduced even if the effective channel width is reduced with reduction of the dimensions of the elements.

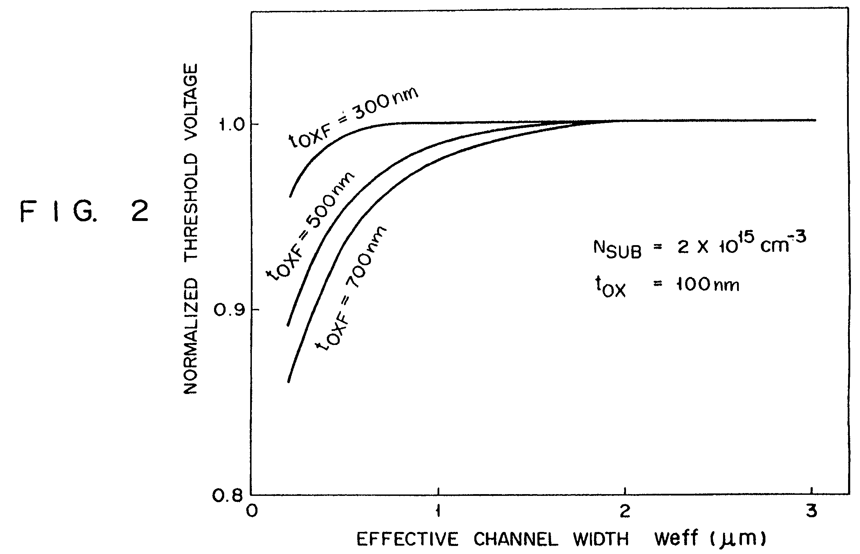

However, it has been confirmed by experiments and numerical calculations that, according to the BOX process, the threshold voltage is reduced with the reduction of the effective channel width. Fig. 2 illustrates how the threshold voltage changes with the effective channel width Weff in devices whose insulating films 12 are 300 nm (3,000 Å), 500 nm (5,000 Å) and 700 nm (7,000 Å) thick, whose substrates 10 have an impurity concentration $N_{SUB}$ of $2 \times 10^{15}$ cm$^{-3}$, and whose gate insulating films 14 are 100 nm (1,000 Å) thick. This characteristic, i.e., reduction of the threshold voltage with reduction of the effective channel width, is an undesirable characteristic of the element. Generally, it is desired that the threshold voltage be independent of the effective channel width.

It is accordingly the object of this invention to provide a semiconductor device including an insulating film deposited in substrate recesses surrounding a transistor formation region, in which the threshold voltage is independent of the effective channel width.

To attain this object, the semiconductor device according to the invention comprises a silicon substrate having a transistor region, forming a channel of a field effect transistor; said channel having a channel width of 1µm or less; and an insulating film filling up recesses formed in the part of said silicon substrate surrounding said transistor region, the sidewall of said transistor region located in said recesses forming an angle θ with the imaginary extension of the top surface of said transistor region, characterized in that: the angle θ is defined as :

$$\theta \leq -0.02778\varepsilon_i^3 + 0.2778\varepsilon_i^2 - 1.639\varepsilon_i + 88.39,$$
$$\theta \geq -0.009259\varepsilon_i^3 - 0.2222\varepsilon_i^2 - 2.528\varepsilon_i + 76.76$$
$$\theta \geq 50°$$

and $\varepsilon_i \geq 1$, where $\varepsilon_i$, is the relative permittivity of the insulating film.

With the above construction, it is possible to prevent the reduction of the threshold voltage with a reduction of the channel width. Thus, the design of the semiconductor device can be facilitated. Further, if the shape of the recesses is varied due to fluctuations of the manufacturing conditions, the threshold voltage is subject to fewer fluctuations. Thus, it is possible to improve the yield of the semiconductor device.

The above and further objects and advantages of the invention will become more apparent from the following description taken in conjunction with the accompanying drawings, in which:

Fig. 1 is a sectional view showing a prior art semiconductor device based on the BOX process;

Fig. 2 is a graph showing the relation between the normalized threshold voltage and effective channel width Weff in a prior art semiconductor device;

Fig. 3 is a sectional view showing a semiconductor device according to the present invention;

Fig. 4 is a graph showing the relation between normalized threshold voltage and effective channel width Weff in a case where the relative permittivity of the insulating film is 3.9;

Fig. 5 is a graph showing the relation between normalized threshold voltage and effective channel width Weff in a case where the relative permittivity of the insulating film is 10;

Fig. 6 is a graph showing the relation between the variation $\Delta V_T$ of the threshold voltage and the angle θ in Fig. 3 in a case where the effective channel width Weff is 0.2 µ;

Fig. 7 is a graph showing the permissible scope of relative permittivity $\varepsilon_i$, and angle θ in the semiconductor device according to the present invention; and

Fig. 8 is a sectional view showing a different embodiment of the semiconductor device according to the present invention.

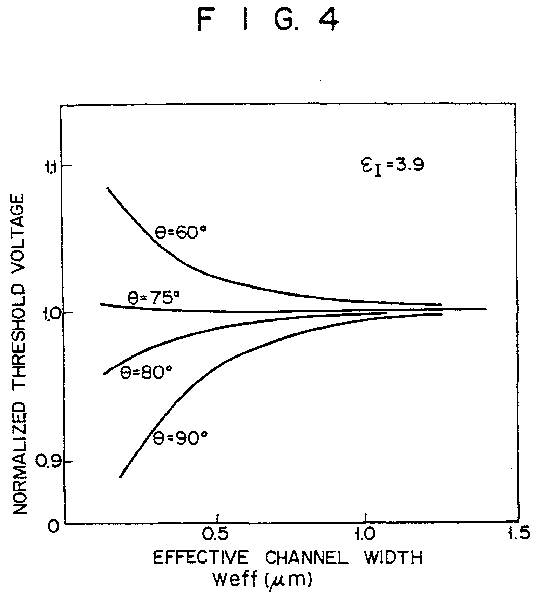

One embodiment of the semiconductor device according to the invention will now be described with reference to Fig. 3. In the BOX process, a silicon substrate 10 is selectively etched except for a region 20 where transistors are to be formed. As a result the recesses are formed in the part of the semiconductor substrate surrounding the region 20. The region 20 is formed such that its side wall 22 and the imaginary extension of the top surface 24 define an angle $\theta$ ($\theta \leq 90°$). Such a structure may be obtained by means of reactive ion etching using a mask having inclined edges on the region 20. Alternatively, various values of angle $\theta$ may be obtained by etching the substrate with different concentrations of $CF_{3+}$ in $CF_4$. An ion implantation layer 18 for preventing an inversion layer from forming is formed in a superficial portion of the etched regions of the semiconductor substrate 10. A field insulation film 12 is formed on the ion implantation layer 18 such that it is contiguous to the side walls 22 of the region 20. A gate electrode 16 is formed over the region 20 with a gate insulating film 14 with a thickness $t_{ox}$ of 100 nm (1,000 Å) interposed therebetween. Preferably, the gate insulating film 14 and field insulation film 12 may be formed such that their surfaces are flush with each other. The gate electrode 16 is preferably formed to have a greater width than the width of the top surface 14 of the region 20.

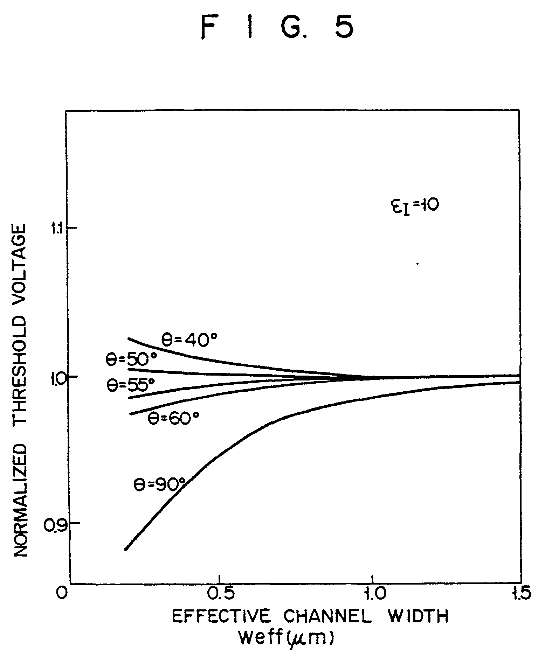

Fig. 4 shows the dependency of the threshold voltage of the MOS transistor on the effective channel width Weff. The curves shown are obtained for various values of the angle $\theta$ by setting the impurity concentration $N_{SUB}$ of the silicon substrate 10 to $2 \times 10^{15}$ $cm^{-3}$, and the thickness of the field insulation film $t_{OXF}$ to 500 nm (5,000 Å) and forming the gate insulating film 14 and field insulation film 12 with silicon oxide having a relative permittivity of $\varepsilon_i = 3.9$. The ordinate is normalized in terms of the threshold voltage of a MOS transistor having a large channel width. As is seen from Fig. 4, the threshold voltage changes as the effective channel width becomes lower than 1 $\mu$. It was also found that the threshold voltage is independent of the effective channel width when the angle $\theta$ is approximately 76°.

Fig. 5 shows like characteristics in a case where the relative permittivity $\varepsilon_i$, of the gate insulating film 14 and field insulation film 12 is 10. In this case again, the threshold voltage changes considerably as the effective channel width becomes lower than 1 $\mu$m. An ideal characteristic can be obtained when the angle $\theta$ is set to 51°.

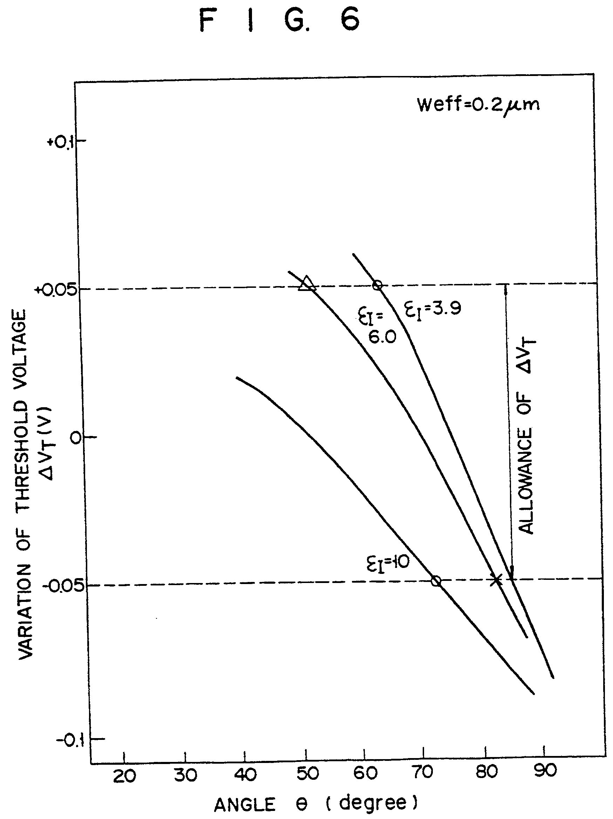

Fig. 6 shows the variation $\Delta V_T$ of the threshold voltage (i.e., the difference thereof from the threshold voltage of a transistor having a large channel width) plotted against the angle $\theta$ in a case where the effective channel width Weff is 0.2 $\mu$m. Various curves are shown for different values of the relative permittivity $\varepsilon_i$. If the allowance of $\Delta V_T$ is set to $\pm 50$ mV, MOS transistors which are substantially free from dependence on the effective channel width can be obtained when the angle $\theta$ is in a range between 63° and 85° with the

relative permittivity $\varepsilon_i$ of 3.9, when the angle $\theta$ is in a range between 52° and 82.5° with the relative permittivity $\varepsilon_i$ of 6.0, and when the angle $\theta$ is less than 72.5° with the relative permittivity $\varepsilon_i$ of 10.

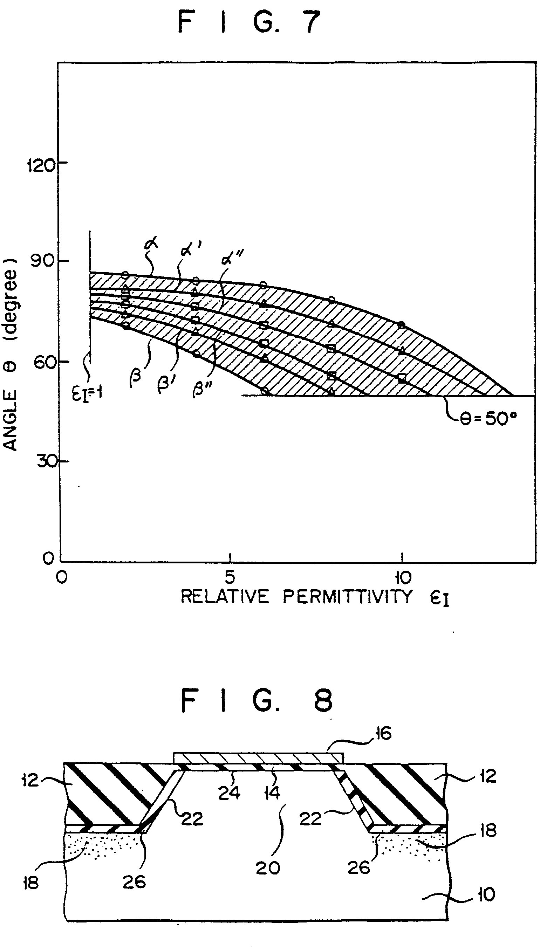

Fig. 7 shows ranges of the optimum values of the angle $\theta$ with respect to various values of the relative permittivity $\varepsilon_i$. The ranges are confined in an area defined by curve $\alpha$, curve $\beta$, curve $\varepsilon_i = 1$ and curve $\theta = 50°$. The relative permittivity of an insulator is always greater than unity, so that $\varepsilon_i \geq 1$ must be met. In addition, if the angle $\theta$ is too small, the dimension of the MOS transistor in the direction of the channel width is excessively increased to reduce the integration density. For this reason, $\theta \geq 50°$ has to be met. The curve a and $\beta$ are given as

$$\theta = -0.2778\varepsilon_i{}^3 + 0.2778\varepsilon_i{}^2 - 1.639\varepsilon_i + 88.39 \quad (1)$$

and

$$\theta = -0.009259\varepsilon_i{}^3 - 0.2222\varepsilon_i{}^2 - 2.528\varepsilon_i + 76.76 \quad (2)$$

Preferably, the allowance of variation $\Delta V_T$ is $\pm 30$ mV. In this case, the curves $\alpha'$ and $\beta'$ representing the upper and lower limits respectively, are given as

$$\theta = -0.2778\varepsilon_i{}^2 + 1.056\varepsilon_i + 81.22 \quad (3)$$

and

$$\theta = -0.00959\varepsilon_i{}^3 - 0.1389\varepsilon_i{}^2 - 1.778\varepsilon_i + 78.93 \quad (4)$$

More preferably, the allowance of $\Delta V_T$ is $\pm 10$ mV. In this case, the curves $\alpha''$ and $\beta''$ representing the upper and lower limits respectively, are given as

$$\theta = 0.0216\varepsilon_i{}^3 - 0.5648\varepsilon_i{}^2 + 1.037\varepsilon_i + 80.51 \quad (5)$$

and

$$\theta = 0.02778\varepsilon_i{}^3 - 0.6944\varepsilon_i{}^2 + 0.8889\varepsilon_i + 78.78 \quad (6)$$

A semiconductor device which is free from any dependency on the effective channel width can be obtained by setting the relative permittivity $\varepsilon_i$ and angle $\theta$ to be contained in the area mentioned above. In particular, it is possible to use a dielectric with a relative permittivity of 5.0 or above, for instance silicon nitride.

In the embodiment described above, the field insulation film 12 is 500 nm (5,000 Å). It may be 300 nm (3,000 Å) to 700 nm (7,000 Å) thick to achieve the same effect as in the embodiment described above. The thickness $t_{OXF}$ of the film 12 is selected according to the type of device. If the device is a CMOS device, the field insulating film 12 functions as an element isolation region and must therefore frequently be much thicker than 500 nm (5,000 Å) to prevent a latch up phenomenon.

If the field insulation film 12 and the gate insulating film 14 are made of silicon oxide having a relative permittivity $\varepsilon_i$ of 3.9, the optimum angle $\theta$ is 76°. The optimum angle $\theta$ changes little if the gate insulating film 14 is made 50 nm (500 Å) or if the silicon substrate 10 has a different impurity concentration $N_{SUB}$. In other words, the angle $\theta$ hardly changes if impurity ions are injected to the substrate 10 to form a channel stopper or if they are injected into the channel region to adjust the threshold voltage.

While in the above embodiment the insulating film has been deposited directly in the feld region, this is by no means limitative. For example, as shown in Fig. 8, a thermal oxide film 26 having a thickness such as not to substantially change the shape of the semiconductor substrate, for instance approximately 50 nm (500 Å), may be formed in the recesses formed in the substrate, and the insulating film 12 may be deposited on the thermal oxide film 26. Further, the invention is applicable not only to a semiconductor device of an enhancement type but also to a semiconductor device of a depletion type. Further, the invention is applicable to both N and P channel semiconductor devices.

## Claims

1. A semiconductor device comprising:

a silcon substrate (10) having a transistor region (20), forming a channel of a field effect transistor; said channel having a channel width of 1 µm or less; and

an insulating film (12) filling up recesses formed in the part of said silicon substrate surrounding said transistor region, the sidewall (22) of said transistor region located in said recesses forming an angle θ with the imaginary extension of the top surface (24) of said transistor region,

characterized in that:

the angle θ is defined as :

$$\theta \leq -0.02778\varepsilon_i^3 + 0.2778\varepsilon_i^2 - 1.639\varepsilon_i + 88.39,$$
$$\theta \geq -0.009259\varepsilon_i^3 - 0.2222\varepsilon_i^2 - 2.528\varepsilon_i + 76.76$$
$$\theta \leq 50°$$

and $\varepsilon_i \geq 1$, where $\varepsilon_i$ is the relative perminivity of the insulating film.

2. A semiconductor device according to claim 1, characterized in that the thickness of said insulating film ranges between 300 and 700 nm.

3. A semiconductor device according to claim 1, characterized in that a gate electrode (16) is formed on said transistor region of said silicon substrate with a gate insulating film (14) interposed there-between, said gate insulating film being substantially flush with said insulating film.

4. A semiconductor device according to claim 3, characterized in that said gate electrode (16) extends onto said insulating film (12).

5. A semiconductor device according to claim 1, characterized in that said insulating film (12) is formed in said recesses of said silicon substrate with a thermal oxide film (26) interposed there-between, said thermal oxide film having such a thickness as not to substantially change the shape of said recesses.

## Revendications

1. Dispositif à semiconducteur comprenant:

un substrat de silicium (10) comportant une région de transistor (20), dans laquelle un transistor à effet de champ ayant une largeur de canal de 1 µm ou moins est formé; et

un film isolant (12) remplissant des cavités formées dans la partie du substrat de silicium entourant la région de transistor, la paroi latérale (22) de la région de transistor située dans les cavités formant un angle θ avec le prolongement fictif de la surface supérieure (24) de la région de transistor,

caractérisé en ce que:

l'angle θ est défini comme:

$$\theta \leq -0.02778\varepsilon_i^3 + 0.2778\varepsilon_i^2 - 1.639\varepsilon_i + 88.39,$$
$$\theta \geq -0.009259\varepsilon_i^3 - 0.2222\varepsilon_i^2 - 2.528\varepsilon_i + 76.76$$
$$\theta \geq 50°$$

et $\varepsilon_i \geq 1$, où $\varepsilon_i$ est la constante diélectrique relative du film isolant.

2. Dispositif à semiconducteur selon la revendication 1, caractérisé en ce que l'épaisseur du film isolant est comprise entre 300 nanomètres et 700 nanomètres.

3. Dispositif à semiconducteur selon la revendication 1, caractérisé en ce qu'une électrode de grille (16) est formée sur la région de transistor du substrat de silicium, un film isolant de grille (14) étant interposé entre celles-ci, le film isolant de grille étant sensiblement au ras du film isolant.

4. Dispositif à semiconducteur selon la revendication 3, caractérisé en ce que l'électrode de grille (16) s'étend jusque sur le film isolant (12).

5. Dispositif à semiconducteur selon la revendication 1, caractérisé en ce que le film isolant (12) est formé dans les cavités du substrat de silicium, un film d'oxyde thermique (26) étant interposé entre ceux-ci, ce film d'oxyde thermique ayant une épaisseur telle qu'elle ne change pas substantiellement la forme des cavités.

## Patentansprüche

1. Halbleiteranordnung mit einem einen Transistorbereich (20) aufweisenden

Siliziumsubstrat (10), der einen Kanal eines Feldeffekttransistors bildet, wobei der Kanal eine Kanalbreite von 1 µm oder weniger aufweist;

und einem Isolierfilm (12), der Vertiefungen ausfüllt, die in dem den Transistorbereich umgebenden Teil des Siliziumsubstrats gebildet sind, wobei die sich in den Vertiefungen befindliche Seitenwand (22) des Transistorbereichs einen Winkel θ zu der imaginären Verlängerung der oberen Oberfläche (44) des Transistorbereichs bildet,

dadurch **gekennzeichnet,**

daß der Winkel θ ist als:

$$\theta \leq -0.02778\varepsilon_i^3 + 0.2778\varepsilon_i^2 - 1.639\varepsilon_i + 88.39,$$
$$\theta \geq -0.009259\varepsilon_i^3 - 0.2222\varepsilon_i^2 - 2.528\varepsilon_i + 76.76$$
$$\theta \geq 50°$$

und $\varepsilon_i \geq 1$, in welchen $\varepsilon_i$ die relative Dielektrizitätskonstante des Isolierfilms ist.

2. Halbleiteranordnung nach Anspruch 1, dadurch **gekennzeichnet**, daß die Dicke des Isolierfilms zwischen 300 und 700 nm liegt.

3. Halbleiteranordnung nach Anspruch 1, dadurch **gekennzeichnet**, daß eine Gateelektrode (16) auf dem Transistorbereich des Siliziumsubstrats mit einem dazwischen gebildeten Gateisolierfilm (14) gebildet ist, wobei der Gateisolierfilm im wesentlichen mit dem Isolierfilm fluchtet.

4. Halbleiteranordnung nach Anspruch 3, dadurch **gekennzeichnet**, daß sich die Gate- elektrode (16) auf den Isolierfilm (12) erstreckt.

5. Halbleiteranordnung nach Anspruch 1, dadurch **gekennzeichnet**, daß der Isolierfilm (12) in den Vertiefungen des Siliziumsubstrats mit einem dazwischen gebildeten Thermo-Oxidfilm (26) gebildet ist, wobei der Thermo-Oxidfilm eine derartige Dicke aufweist, daß die Form der Vertiefungen nicht wesentlich geändert ist.

F I G. 1

F I G. 3

FIG. 2

Effective channel width Weff (μm), Normalized threshold voltage

$N_{SUB} = 2 \times 10^{15}$ cm$^{-3}$

$t_{OX} = 100$ nm

$t_{OXF} = 300$ nm

$t_{OXF} = 500$ nm

$t_{OXF} = 700$ nm

# F I G. 4

F I G. 5

NORMALIZED THRESHOLD VOLTAGE

EFFECTIVE CHANNEL WIDTH Weff(μm)

$\epsilon_I = 10$

θ=40°
θ=50°
θ=55°
θ=60°
θ=90°

# F I G. 6

# F I G. 7

# F I G. 8